(19)

Europäisches Patentamt
European Patent Office
Office européen des brevets

(11) **EP 1 739 726 A1**

(12) **EUROPEAN PATENT APPLICATION**
published in accordance with Art. 158(3) EPC

(43) Date of publication:
**03.01.2007 Bulletin 2007/01**

(21) Application number: **05721512.1**

(22) Date of filing: **25.03.2005**

(51) Int Cl.:
*H01L 21/20* (2006.01)    *H01L 21/205* (2006.01)
*H01L 21/302* (2006.01)   *H01L 21/331* (2006.01)
*H01L 21/336* (2006.01)   *H01L 29/73* (2006.01)
*H01L 29/74* (2006.01)    *H01L 29/78* (2006.01)
*H01L 29/861* (2006.01)

(86) International application number:
**PCT/JP2005/005585**

(87) International publication number:
**WO 2005/093796 (06.10.2005 Gazette 2005/40)**

(84) Designated Contracting States:
**DE FR IT SE**

(30) Priority: **26.03.2004 JP 2004092666**

(71) Applicants:
• **THE KANSAI ELECTRIC POWER CO., INC.**
**Osaka-shi,**
**Osaka 530-8270 (JP)**
• **Central Research Institute of Electric Power**
**Industry**
**Tokyo 100-8126 (JP)**

(72) Inventors:
• **NAKAYAMA, Koji,**
**The Kansai Electric Power Co. Inc.**
**Osaka-shi, Osaka 5308270 (JP)**
• **SUGAWARA, Yoshitaka,**
**The Kansai El. Power Co. Inc.**
**Osaka-shi, Osaka 5308270 (JP)**

• **TSUCHIDA, Hidekazu,**
**Materials Sc. Research Lab.**
**Yokosuka-shi, Kanagawa 2400196 (JP)**
• **KAMATA, Isaho,**
**Materials Science Research Lab.**
**Yokosuka-shi, Kanagawa 2400196 (JP)**
• **MIYANAGI, Toshiyuki,**
**Materials Sc. Research Lab.**
**Yokosuka-shi, Kanagawa 2400196 (JP)**
• **NAKAMURA, Tomonori,**
**Materials Science Research Lab**
**Yokosuka-shi, Kanagawa 2400196 (JP)**

(74) Representative: **Hall, Matthew Benjamin**
**Frank B. Dehn & Co.**
**St Bride's House**
**10 Salisbury Square**
**London EC4Y 8JD (GB)**

(54) **BIPOLAR SEMICONDUCTOR DEVICE AND PROCESS FOR PRODUCING THE SAME**

(57)    A process for manufacturing a bipolar type semiconductor device in which at least a part of a region where an electron and a hole are recombined during current flowing is formed with a silicon carbide epitaxial layer that has been grown from the surface of a silicon carbide substrate, is **characterized by** that the surface of the silicon carbide substrate is treated by hydrogen etching and the epitaxial layer is then formed by the epitaxial growth of silicon carbide from the treated surface. A propagation of a basal plane dislocation to the epitaxial layer can be further reduced by treating the surface of the silicon carbide substrate by using chemical mechanical polishing and hydrogen etching in this order.

FIG. 3

EP 1 739 726 A1

**Description**

TECHNICAL FIELD

The present invention relates to a bipolar type semiconductor device and its manufacturing process in which a region where an electron and a positive hole are recombined during current flowing, such as a drift layer, is formed with a silicon carbide epitaxial layer that has been grown from the surface of a silicon carbide substrate, in particular to a reduction of a basal plane dislocation density in the epitaxial layer and an improvement of a forward voltage degradation due to long-term operation.

BACKGROUND ART

Silicon carbide (SiC) is a semiconductor that has excellent material property values for a coefficient of thermal conductivity, electron mobility, and a band gap, in addition to the dielectric breakdown field strength of approximately ten times as strong as that of silicon (Si). Accordingly, silicon carbide is expected as a semiconductor material for implementing rapid performance improvement as compared with conventional Si power semiconductor devices. Recently, 4H-SiC and 6H-SiC monocrystal substrates with a diameter of up to three inches have been put on the market. In addition, many kinds of switching devices have been reported, such as a Schottky barrier diode (SBD), a high voltage pn diode, and a MOSFET that have a performance greatly exceeding the performance limit of Si. Thus high performance SiC devices are being developed.

Semiconductor devices can be classified roughly into a unipolar device in which only an electron or a hole acts to conduction during current flowing and a bipolar device in which both an electron and a hole act to conduction during current flowing. As examples of the unipolar device, devices such as a Schottky barrier diode (SBD), a junction field effect transistor (J-FET), and a metal oxide film semiconductor field effect transistor (MOS-FET) are given. As examples of the bipolar device, devices such as a pn diode, a bipolar junction transistor (BJT), a thyristor, a GTO thyristor, and an IGBT are given.

As described in the Non-patent document 1, a conventional SiC bipolar device shows degradation due to long-term operation in which a forward voltage is increased corresponding to an increase in current flowing time (integrated usage time) after current flowing is started to a new bipolar device.

It is thought that such degradation of a forward voltage is caused by a basal plane dislocation, which is a kind of crystal faults. The basal plane dislocation is converted to a stacking fault by recombination energy of an electron and a hole that are generated during current flowing. An area of the stacking fault increases according to an increase in current flowing time. Since a region of the stacking fault acts as a high resistance region during current flowing, a forward voltage of a bipolar device is increased corresponding to an increase in an area of the stacking fault. In the case in which a forward voltage is increased, a loss of an device increases, thus increasing a loss and degrading the reliability for a power conversion device such as an inverter using such an device.

In the case in which a power semiconductor device is formed with SiC monocrystal, deep diffusion of impurities is difficult since a diffusion coefficient of the SiC monocrystal is extremely small. Accordingly, the epitaxial growth of a monocrystal film is frequently carried out with the specified film thickness and doping concentration on an SiC monocrystal substrate based on the crystal type same as that of the SiC monocrystal substrate (see Patent Document 1 for reference).

For SiC monocrystal, 3C-SiC, 4H-SiC, and 6H-SiC poly types of crystal are used in general. In particular, 4H-SiC is mainly used for developing power semiconductors since it has high dielectric breakdown strength, high mobility, and comparatively small anisotropy. For instance, the crystal plane in which the epitaxial growth is carried out is the (0001) Si plane, (000-1) C plane, (11-20) plane, (01-10) plane, or (03-38) plane, etc. In the case in which the epitaxial growth is carried out on the (0001) Si plane or (000-1) C plane, a crystal plane that has been inclined at several degrees to the [11-20] direction or the [01-10] direction from the C axis is frequently used for the homo-epitaxial growth with the step flow growth technology.

The SiC monocrystal substrate that grows an epitaxial monocrystal film can be obtained by slicing a bulk crystal that has been formed by the sublimation method or the chemical vapor deposition (CVD) method, and by the mechanical polishing of the surface of the bulk crystal with polishing abrasive grains harder than or equivalent to SiC. A basal plane dislocation exists at a high density in the (0001) plane on the SiC monocrystal substrate that has been obtained by the sublimation method or the CVD method. In the case in which the epitaxial growth is carried out on the (0001) Si plane or (000-1) C plane and a crystal plane that has been inclined at several degrees (referred to as an off-angle) to the [11-20] direction or the [01-10] direction from the C axis is used, a basal plane dislocation that exists in the (0001) plane on the SiC monocrystal substrate appears on the surface of the SiC monocrystal substrate.

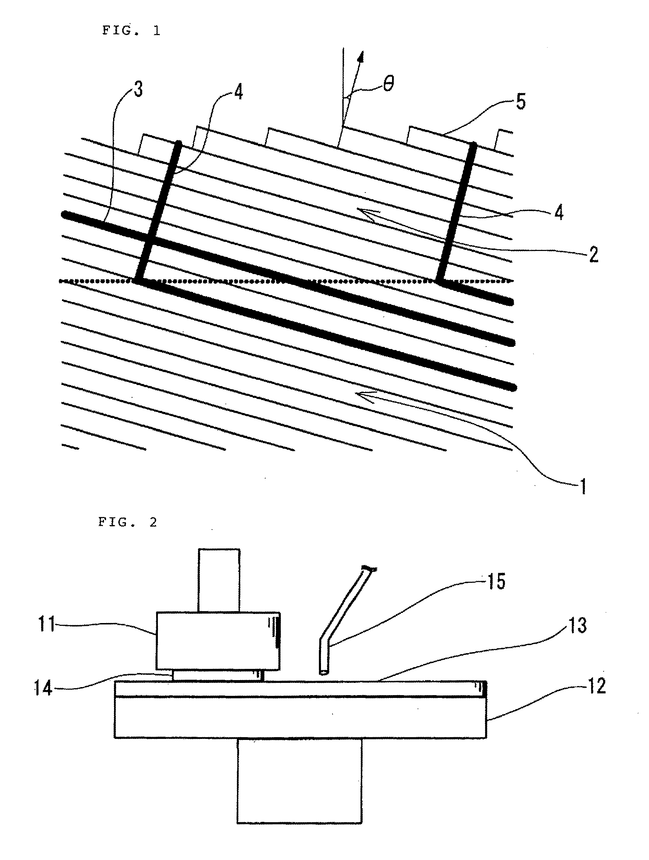

For instance, for the SiC monocrystal substrate in which a crystal plane has been inclined at an off-angle of 8° from the (0001) Si plane and (000-1) C plane, a basal plane dislocation density on the surface of the substrate is in the range of $10^2$ to $10^4$/cm$^2$ in general (the density depends on crystal quality). As schematically shown in Fig. 1, about several percents of a basal plane dislocation 3 on the surface of a substrate 1 are propagated to an epitaxial layer 2 as the basal plane dislocation 3 during an epitaxial growth, and the remainder of the basal plane dislocation 3 is converted to a threading edge dislocation 4 and propagated to the epitaxial layer 2. In Fig. 1, numeral 5 represents a (0001) Si plane and symbol θ represents an off-angle.

In the case in which a bipolar device is fabricated by using the SiC substrate with an epitaxial film that has been obtained as described above, a region in which a basal plane dislocation is converted to a stacking fault during current flowing is a region in which an electron and a hole are recombined during current flowing. Most of the region in which an electron and a hole are recombined is a drift layer of a bipolar device, and a part of electrons and holes is penetrated to the injection layer side around the interface of the drift layer and the injection layer. To suppress the degradation of a forward voltage due to current flowing, it is thought to be effective that a basal plane dislocation density is reduced in those regions.

Patent Document 1: International Patent Laid-Open Pamphlet WO03/038876

Non-patent document 1: Materials Science Forum, 2002, Vol. 389 to 393, p. 1259 to 1264

DISCLOSURE OF THE INVENTION

PROBLEMS TO BE SOLVED BY THE INVENTION

The present invention has been made in order to solve the above problems in prior arts. An object of the present invention is to provide a bipolar type semiconductor device and its manufacturing process in which a propagation of a basal plane dislocation from an SiC monocrystal substrate to an epitaxial layer can be reduced and thereby the degradation of a forward voltage due to long-term operation can be suppressed.

MEANS FOR SOLVING THE PROBLEMS

The present inventor has carried out a hydrogen etching treatment to the surface of the SiC monocrystal substrate under the specified conditions before carrying out an epitaxial growth of SiC on the SiC monocrystal substrate. As a result, the present inventor has achieved the present invention by finding that a basal plane dislocation in the epitaxial film that has been grown from the treated surface is greatly reduced.

Moreover, the present inventor has treated the surface of the substrate by chemical mechanical polishing and then carried out a hydrogen etching treatment to the surface of the substrate. As a result, the present inventor has achieved the present invention by finding that a basal plane dislocation in the epitaxial film that has been grown from the treated surface by using the substrate with a low off-angle is greatly reduced.

In particular, in the case in which an epitaxial growth is carried out from the surface of the substrate with a surface roughness Rms in the range of 0.1 to 0.6 nm by the above described treatments, the basal plane dislocation can be greatly reduced.

A bipolar type semiconductor device with relation to the present invention in which at least a part of a region where an electron and a hole are recombined during current flowing is formed with a silicon carbide epitaxial layer that has been grown from the surface of a silicon carbide substrate, is characterized by that a surface roughness Rms of the surface of the silicon carbide substrate on which an epitaxial growth is carried out is in the range of 0.1 to 0.6 nm.

A bipolar type semiconductor device with relation to the present invention is characterized by that an off-angle of the silicon carbide substrate is in the range of 1 to 4°.

A bipolar type semiconductor device with relation to the present invention is characterized by that a crystal plane of the silicon carbide substrate in which the epitaxial growth is carried out is the (000-1) C plane and an off-angle of the substrate is in the range of 1 to 8°.

A process for manufacturing a bipolar type semiconductor device with relation to the present invention in which at least a part of a region where an electron and a hole are recombined during current flowing is formed with a silicon carbide epitaxial layer that has been grown from the surface of a silicon carbide substrate, is characterized by that the surface of the silicon carbide substrate is treated by hydrogen etching and the epitaxial layer is then formed by the epitaxial growth of silicon carbide from the treated surface.

A process for manufacturing a bipolar type semiconductor device with relation to the present invention in which at least a part of a region where an electron and a hole are recombined during current flowing is formed with a silicon carbide epitaxial layer that has been grown from the surface of a silicon carbide substrate, is characterized by that the surface of the silicon carbide substrate is treated by chemical mechanical polishing and hydrogen etching in this order, and that the epitaxial layer is then formed by the epitaxial growth of silicon carbide from the treated surface.

A process for manufacturing a bipolar type semiconductor device with relation to the present invention is characterized by that the epitaxial growth is carried out from the surface of the silicon carbide substrate with an off-angle in the range of 1 to 4°.

A process for manufacturing a bipolar type semiconductor device with relation to the present invention is characterized by that the epitaxial growth is carried out from the (000-1) C plane of the silicon carbide substrate with an off-angle in the range of 1 to 8°.

EFFECT OF THE INVENTION

According to a bipolar type semiconductor device related to the present invention, a basal plane dislocation in an epitaxial layer can be greatly reduced.

According to the manufacturing process of a bipolar type semiconductor device related to the present invention, the propagation of a basal plane dislocation from an SiC monocrystal substrate to an epitaxial layer can be greatly reduced.

BRIEF DESCRIPTION OF THE DRAWINGS

Fig. 1 is a view for illustrating the propagation of a basal plane dislocation from an SiC monocrystal substrate to an epitaxial layer.

Fig. 2 is a schematic configuration view of a CMP apparatus.

Fig. 3 is a cross-sectional view for showing an example of a pn diode formed by using an SiC substrate with an epitaxial film in which the surface of the substrate has been treated by the method with relation to an embodiment of the present invention.

Fig. 4 is a graph indicating the measurement results of a basal plane dislocation density in the epitaxial film with relation to an embodiment and a comparison example of the present invention.

Fig. 5 is a view for illustrating the configuration for suppressing a basal plane dislocation to an epitaxial film with relation to the present invention.

EXPLANATIONS OF LETTERS OR NUMERALS

1: SiC monocrystal substrate
2: SiC epitaxial layer
3: Basal plane dislocation
4: Threading edge dislocation
5: Crystal plane
11: Polishing head
12: Turn table
13: Polishing pad
14: Substrate
15: Slurry supply nozzle
21: Substrate
23: Drift layer
24: p-type junction layer
25: p$^+$-type contact layer
26: Junction termination extension (JTE)
27: Oxide film
28: Cathode electrode
29: Anode electrode
29a: Titanium film
29b: Aluminum film
41: Basal plane dislocation
41a: Imaging dislocation
42: Atomic step
43: Bunching step

d: Distance between a basal plane dislocation and a surface

θ: Off-angle

BEST MODE OF CARRYING OUT THE INVENTION

An embodiment of the present invention will be described below in detail. For the lattice orientation and lattice plane in the present description, an individual orientation and an individual plane are represented by [] and (), respectively. Although a negative index is subject to attachment of "-" (bar) over a number based on crystallography, a negative sign is instead attached in front of the number in order to prepare the present patent specification.

An SiC monocrystal substrate is formed by slicing a bulk crystal that has been obtained by the sublimation method or CVD method. In the sublimation method (modified Lely method), SiC powder that has been put into a crucible is heated at the range of 2200 to 2400°C for vaporization, and is deposited on the surface of the seed crystal at a speed of the range of 0.8 to 1 mm per hour in general for bulk growth. The formed ingot is sliced at the specified thickness in such a manner that a desired crystal plane is exposed. The surface of the SiC monocrystal substrate is smoothed in the specular morphology by a treatment of polishing with abrasive grains harder than or equivalent to SiC, or the like. The rough abrasive grains are exchanged to fine abrasive grains as the polishing is progressed.

For instance, a crystal type of SiC monocrystal such as 4H-SiC, 3C-SiC, 2H-SiC, 6H-SiC, and 15R-SiC can be used in general. Among these types, 4H-SiC is preferably used in particular since it has high dielectric breakdown strength, high mobility, and comparatively small anisotropy. In the case in which the 4H-SiC is used, a basal plane dislocation density in an epitaxial layer can be greatly reduced by carrying out a hydrogen etching treatment or carrying out both the hydrogen etching treatment and chemical mechanical polishing treatment.

For instance, the crystal plane in which the epitaxial growth is carried out is the (0001) Si plane, (000-1) C plane, (11-20) plane, (01-10) plane, or (03-38) plane, etc. In the case in which the epitaxial growth is carried out on the (0001) Si plane or (000-1) C plane, a substrate is cut while being inclined at an off-angle of the range of 1 to 12°, preferably the range of 1 to 8°, particularly preferably the range of 1 to 4°, to the off-orientation of the [01-10] direction, the [11-20] direction, or a middle direction between the [01-10] direction and [11-20] direction, and the epitaxial growth from the crystal plane is carried out by the step flow growth technology.

In the case in which a substrate is cut at a low off-angle of the range of 1 to 4°, a propagation of a basal plane dislocation from the substrate to an epitaxial layer can be greatly reduced. In addition, in the case in which the crystal plane of the substrate in which the epitaxial growth is carried out is the (000-1) C plane, a propagation of a basal plane dislocation to an epitaxial layer can be greatly reduced even if the off-angle is comparatively larger than the range of 1 to 4°. In detail, even in the case in which the off-angle is in the range of 1 to 8°, a propagation of a basal plane dislocation from the substrate to the epitaxial layer can be greatly reduced.

The surface of the SiC monocrystal substrate is treated by the hydrogen etching. For instance, the hydrogen etching can be carried out in the reactor in which the epitaxial growth is carried out. After the substrate is set in the reactor, a hydrogen gas or a hydrogen gas to which hydrogen chloride has been added is supplied into the reactor at the range of 1 to 100 L/min, preferably the range of 5 to 20 L/min. The treatment for the range of 10 to 60 minutes is then carried out at the range of 1300 to 1700°C, preferably the range of 1350 to 1450°C, in the gas ambient atmosphere of the range of 10 to 250 Torr, preferably the range of 20 to 50 Torr.

The removal speed of Si during an interaction of hydrogen and the surface of the substrate is determined mainly depending on an evaporation rate, and the removal speed of C is determined mainly depending on a reaction speed with hydrogen. By etching treatment is carried out at a temperature and a pressure under which the emission speeds of Si and C are almost equivalent, a basal plane dislocation density in the SiC epitaxial layer that is grown from the surface of the substrate can be greatly reduced.

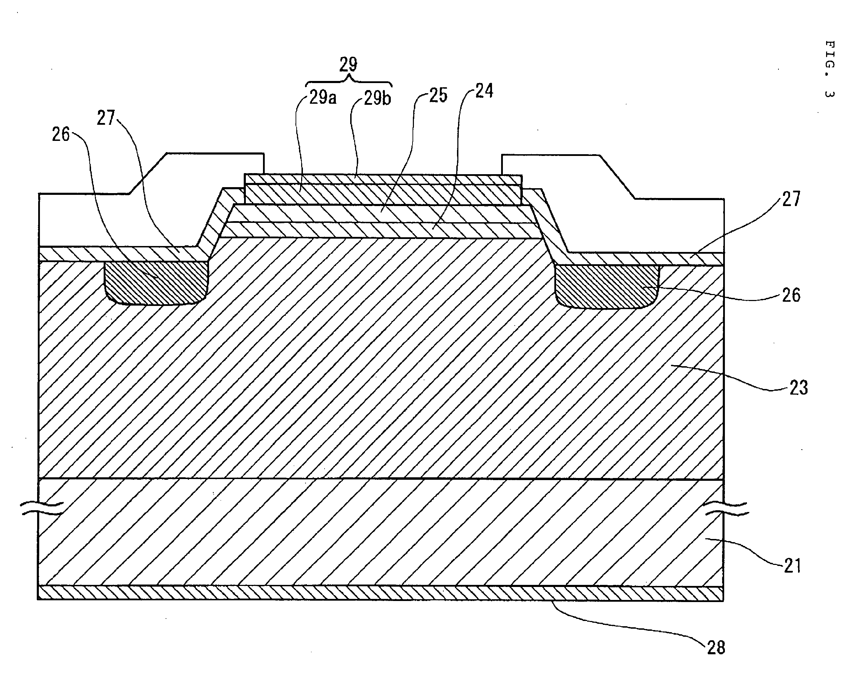

A basal plane dislocation density to the epitaxial layer can be greatly reduced by treating the surface of the substrate with the chemical mechanical polishing before carrying out the above hydrogen etching treatment. Fig. 2 shows the schematic configuration of a general CMP apparatus. An SiC monocrystal substrate 14 is fixed to a polishing head 11, and is pressed to a polishing pad 13 on a turn table 12. In this state, while a polishing slurry is dropped from a slurry supply nozzle 15, either of or both of the polishing pad 13 and the SiC monocrystal substrate 14 is rotated by a rotation motor, and the SiC monocrystal substrate 14 is polished by the chemical or mechanical action. A polishing slurry is composed of a solvent, abrasive grains, and an addition agent in general. For instance, fine silica grains such as colloidal silica are dispersed in water as abrasive grains, and a necessary addition agent is added to fine silica grains in water for adjusting pH.

After the surface of the substrate is treated by the above method, the epitaxial growth of SiC from the treated surface is carried out by the CVD method. Propane is used as the source gas of carbon, and silane is used as the source gas of silicon. In addition, hydrogen is used as a carrier gas, and nitrogen or trimethyl aluminum is used as a dopant gas. For instance, the epitaxial growth of SiC is carried out at a growth speed of the range of 2 to 20 μm per hour under the condition of the range of 1500 to 1600°C and 40 to 80 Torr in the gas ambient atmosphere. By the above step, the step flow growth of SiC is carried out with the crystal type same as that of the substrate.

As an actual apparatus for the epitaxial growth, a vertical type hot wall reactor can be used. A water cooling double cylinder tube made of quartz is attached to the vertical type hot wall reactor. A cylindrical heat insulating material, a hot wall made of graphite, and a wedge type suscepter for holding the SiC monocrystal substrate in a vertical direction are installed in the water cooling double cylinder tube. A high frequency heating coil is installed on the external periphery of the water cooling double cylinder tube. The high frequency heating coil is used to heat the hot wall by high frequency induction, and the SiC monocrystal substrate that is held by the wedge type suscepter is heated by radiant heat from the hot wall. The epitaxial growth of SiC is carried out on the surface of the SiC monocrystal substrate by supplying a reaction gas from the lower section of the water cooling double cylinder tube while heating the SiC monocrystal substrate.

A bipolar device is fabricated by using SiC with an epitaxial film that has been obtained as described above. As examples of the bipolar device, devices such as a pn diode, a bipolar junction transistor (BJT), a thyristor, a GTO thyristor, and an IGBT are given.

A region where an electron and a hole are recombined during current flowing, such as a drift layer or an injection layer around the interface of the drift layer and the injection layer, is formed in the above described epitaxial layer for the bipolar devices. Since the substrate to which the above described treatment has been carried out is used in the present embodiment, a basal plane dislocation density to the epitaxial layer can be greatly reduced. As a result, the generation of a stacking fault that is converted from a basal plane dislocation during current flowing can be suppressed, and a forward voltage degradation due to long-term operation can be improved. In particular, in the case in which an epitaxial growth is carried out from the surface of the substrate with a surface roughness Rms in the range of 0.1 to 0.6 nm, preferably in the range of 0.1 to 0.3 nm, by the above described treatment, the basal plane dislocation can be greatly reduced.

It is thought that the propagation of a basal plane dislocation to an epitaxial layer can be greatly reduced in the present invention by the following reasons. The configuration that will be described below is just examination, and the present invention is not restricted to the following configuration.

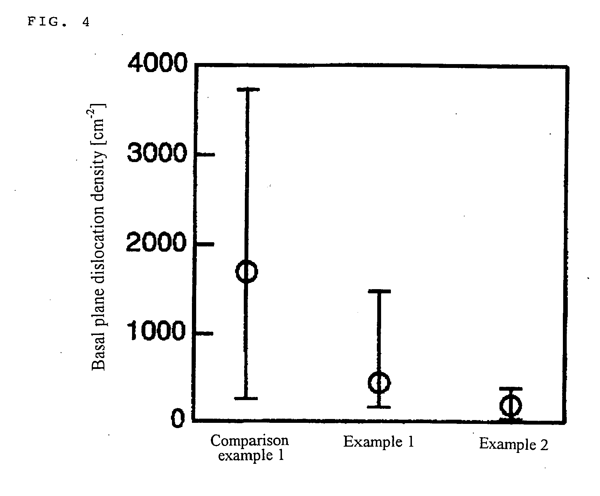

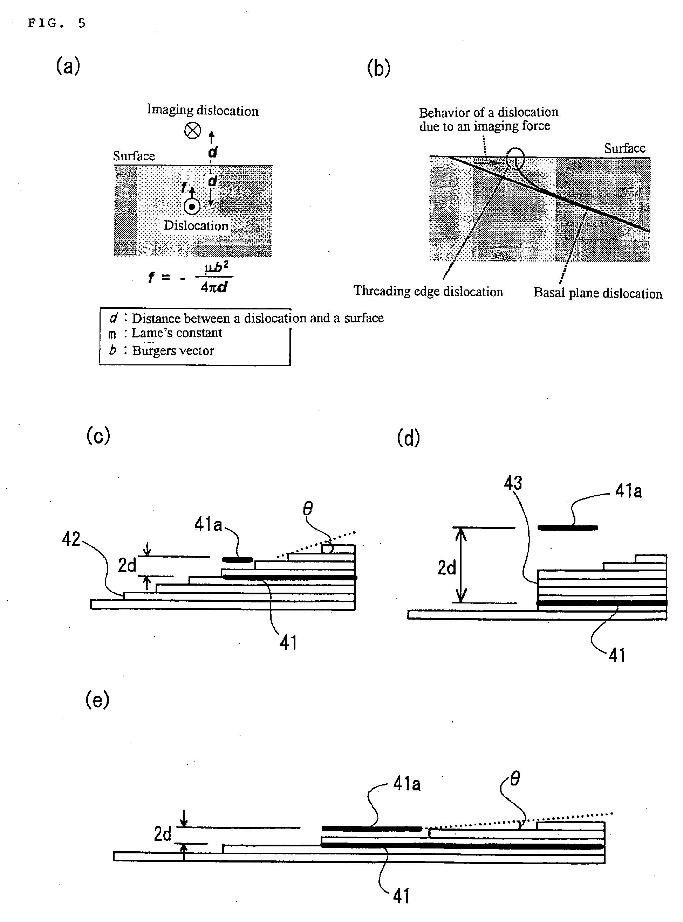

The configuration will be described below with reference to Fig. 5. In general, an imaging force acts between a dislocation that exists in crystal and a crystal surface. The imaging force can be calculated by considering an imaging dislocation. In the case in which a dislocation having the Burgers vector of an absolute value b exists at a distance r from the crystal surface, a force F of a dislocation having an imaging relation with the dislocation (an imaging force) is represented by the following equation (see Fig. 5(a)).

$$\text{Imaging force: } F = -\mu b^2 / 4\pi r \text{ (where } \mu \text{ is an elastic coefficient)}$$

It is found from the above equation that an imaging force increases as a distance d from the crystal surface to the dislocation becomes smaller. The value of the imaging force is negative, thus indicating that an attracting force acts between the dislocation and the crystal surface. That is to say, as shown in Fig. 5(b), as the basal plane dislocation approaches to the crystal surface, an attracting force acts to the basal plane dislocation that exists in the SiC monocrystal in such a manner that the basal plane dislocation gradually becomes perpendicular to the crystal surface.

In the case in which the attracting force exceeds a critical value, the basal plane dislocation is converted to a threading edge dislocation that is propagated in the direction almost perpendicular to the crystal surface (direction parallel to a C axis).

In the case in which the epitaxial growth is carried out on the (0001) Si plane or (000-1) C plane of the SiC monocrystal substrate, a crystal plane that has been inclined at several degrees from the C axis is used. Accordingly, the surface of the epitaxial film includes the stepped surface at an atomic level (atomic step) . As shown in Fig. 5 (c), in the case in which individual atomic steps 42 are taken apart for an ideal flat surface, a distance d between the surface of the epitaxial film and a basal plane dislocation 41 that exists in the epitaxial film is minimized, and an imaging force (attracting force) that is applied to the basal plane dislocation 41 from the surface is maximized. Consequently, the basal plane dislocation 41 is propagated inside the epitaxial monocrystal film while changing its direction to that almost perpendicular to the crystal surface (direction of the C axis), that is, while being converted to the threading edge dislocation.

However, as shown in Fig. 5(d), a bunching step 43 in which several atomic steps are bundled exists on an actual crystal surface. In the state in which such a bunching step exists, an imaging force (attracting force) that is applied to the basal plane dislocation 41 from the surface is lowered. Accordingly, the basal plane dislocation 41 is propagated inside the epitaxial monocrystal film without changing its direction to that almost perpendicular to the crystal surface (direction of the C axis), that is, while being almost parallel to the crystal surface.

The state of the atomic step on the crystal surface of the SiC monocrystal substrate during the epitaxial growth changes depending on the surface treatment to the SiC monocrystal substrate. The bunching of the atomic steps on the surface of the substrate is suppressed by carrying out a hydrogen etching treatment that is suitable for the surface of the substrate or carrying out both the hydrogen etching treatment and chemical mechanical polishing treatment that are suitable for the surface of the substrate. The existence of the bunching of the atomic steps on the surface of the substrate and the area size of a bunching step can be measured as a surface roughness Rms macroscopically. The surface roughness Rms can be reduced by carrying out the surface treatments before forming the epitaxial film.

In the case in which the surface roughness Rms of the crystal surface becomes a certain value or less by the surface treatment such as hydrogen etching, it is thought that an imaging force that is applied to the basal plane dislocation exceeds a critical value, and the rate of the basal plane dislocation that is converted to the threading edge dislocation is greatly increased.

By the above configuration, in the case in which an epitaxial growth is carried out from the surface of the substrate with a surface roughness Rms of 0.6 nm or less, in particular 0.3 nm or less, it is thought that the propagation of the basal plane dislocation from the substrate to the epitaxial film can be critically reduced.

In the case in which many kinds of crystal imperfection exist on the surface of the substrate, a new basal plane dislocation may be generated during the epitaxial growth in which a basal plane dislocation is propagated from the substrate to the epitaxial film. In such a case, the density of the basal plane dislocation in the epitaxial film is a sum of basal plane dislocations that are propagated from the substrate to the epitaxial film and new basal plane dislocations that are generated during the epitaxial growth.

A crystal imperfection on the surface of the substrate can be removed by carrying out the chemical mechanical polishing treatment or the hydrogen etching treatment under the suitable conditions and by flattening the surface of the substrate. That is to say, the density of basal plane dislocations that are generated during the epitaxial growth can be reduced by carrying out the chemical mechanical polishing treatment or the hydrogen etching treatment and by reducing the surface roughness of the substrate.

By the above configuration, in the case in which an epitaxial growth is carried out from the surface of the substrate with a surface roughness Rms of 0.6 nm or less, in particular 0.3 nm or less, it is thought that the propagation of the basal plane dislocation from the substrate to the epitaxial film can be critically reduced. Simultaneously, the density of new basal plane dislocations that are generated during the epitaxial growth can also be reduced. As a result, it is thought that the epitaxial film of which the basal plane dislocation density is extremely low can be obtained.

Moreover, as shown in Fig. 5(e), as the off-angle $\theta$ is smaller, the basal plane dislocation 41 is closer to the crystal surface. Accordingly, as the off-angle $\theta$ becomes smaller, an imaging force per unit length that is applied to the basal plane dislocation 41 becomes larger. That is to say, as the off-angle $\theta$ is smaller, the rate of the basal plane dislocation that is converted to the threading edge dislocation during the epitaxial growth becomes higher.

In the case in which the off-angle $\theta$ becomes extremely small, the epitaxial growth on the (0001) Si plane or (000-1) C plane of the SiC monocrystal substrate is difficult. Therefore, the off-angle $\theta$ of 1° or larger is necessary practically. As a result, in the case in which a substrate that has been cut while being inclined at an off-angle of the range of 1 to 12°, preferably the range of 1 to 8°, particularly preferably the range of 1 to 4°, is used, a superior quality epitaxial film to which the propagation of the basal plane dislocation from the substrate is less can be obtained.

In the case in which the (0001) Si plane and the (000-1) C plane are compared, the (000-1) C plane has a property in which step bunching is hard to occur. Consequently, for the (000-1) C plane, an epitaxial layer in which the basal plane dislocation density is extremely small can be obtained even in the case in which the off-angle is in the range of 1 to 8°.

Fig. 3 is a cross-sectional view for showing an example of a pn (pin) diode, which is one of bipolar devices. An ingot that has been grown by the modified Lely method is sliced at the specified off-angle. An n-type 4H-SiC substrate of which the surface has been polished in the specular morphology is treated by hydrogen etching or chemical mechanical polishing under the above conditions to form an SiC monocrystal substrate 21 (with a carrier density of $8 \times 10^{18}$ cm$^{-3}$ and a thickness of 400 $\mu$m). The epitaxial growth of a nitrogen doped n-type SiC layer and that of an aluminum doped p-type SiC layer are then carried out in order on the SiC monocrystal substrate 21 by the CVD method.

A drift layer 23 which is an n-type growth layer has a donor density of $5 \times 10^{14}$ cm$^{-3}$ and a film thickness of 40 $\mu$m.

A p-type growth layer is composed of a p-type junction layer 24 and a p$^+$-type contact layer 25. The p-type junction layer 24 has an acceptor density of $5 \times 10^{17}$ cm$^{-3}$ and a film thickness of 1.5 $\mu$m. The p$^+$-type contact layer 25 has an acceptor density of $1 \times 10^{18}$ cm$^{-3}$ and a film thickness of 0.5 $\mu$m.

The peripheral section of the epitaxial layer is removed by reaction ion etching to form a mesa structure. Aluminum ions are then implanted to the epitaxial layer to form a junction termination extension (JTE) 26 in order to relax an electric field concentration at a mesa bottom. The junction termination extension (JTE) 26 has a total dose of $1.2 \times 10^{13}$ cm$^{-2}$, a width of 250 $\mu$m, and a depth of 0.7 $\mu$m. In the forming process of the junction termination extension (JTE) 26, after ions are implanted at a room temperature while energy is changed in the range of 30 to 450 keV, a heat treatment of 1700°C in the argon gas ambient atmosphere is carried out to activate the implanted ions. Numeral 27 represents a thermal oxide film that has been formed after the implanted ions were activated.

Numeral 28 represents a cathode electrode which has been formed by evaporating Ni (with a thickness of 350 nm) under the bottom surface of the SiC monocrystal substrate 21, and numeral 29 represents an anode electrode which has been formed by evaporating a Ti film 29a (with a thickness of 350 nm) and an Al film 29b (with a thickness of 100 nm) on the p$^+$-type contact layer 25. These electrodes function as an ohmic electrode by a heat treatment of 1000°C for 20 minutes after the evaporation.

For this pn diode, the drift layer 23 is made of an epitaxial film that has been grown from the surface of the SiC monocrystal substrate 21 which has been treated by hydrogen etching and chemical mechanical polishing, thus reducing a basal plane dislocation density in the drift layer 23. Accordingly, a conversion to a stacking fault due to recombination energy of an electron and a hole during current flowing can be suppressed, thus lengthening the life of the device.

While the preferred embodiments of the present invention have been described above, the present invention is not restricted to the embodiments, and various changes and modifications can be thus made without departing from the scope of the present invention.

[Example 1]

An ingot that was grown by an modified Lely method was sliced at an off-angle of 8° to the off-orientation of the [11-20] direction. The surface of the sliced substrate was smoothed in the specular morphology by mechanically polishing the surface with abrasive grains. By using a vertical type hot wall reactor, an etching treatment for 40 minutes was carried out at a temperature of 1400°C and a pressure of 30 Torr to the formed n-type 4H-SiC (0001) substrate while supplying a hydrogen gas at a flow rate of 10 L/min. The surface roughness Rms of the substrate, which was measured by using the interatomic force microscope SPI3800N manufactured by Seiko Instruments Inc. after the treatment, was 0.25 nm (region of 10 $\mu$m × 10 $\mu$m).

Next, the epitaxial growth of SiC from the surface of the substrate was carried out by the CVD method after the treatment. An epitaxial film with a film thickness of 60 $\mu$m was formed by the step flow growth for 4 hours at a temperature of 1545°C and a pressure of 42 Torr while supplying propane (8 cc/min), silane (30 cc/min), and hydrogen (10 L/min).

The basal plane dislocation density in the epitaxial film, which was measured by using the molten KOH etching and X-ray topograph for the SiC monocrystal substrate with the epitaxial film that was obtained, was 440 cm$^{-2}$ on the average.

[Example 2]

The SiC monocrystal substrate with the epitaxial film was obtained similarly to the Example 1 except that the surface of the substrate was treated by chemical mechanical polishing before carrying out a hydrogen etching treatment. The surface roughness Rms of the substrate, which was measured based on the method same as that of the Example 1 after the treatment, was 0.20 nm (region of 10 $\mu$m × 10 $\mu$m).

The basal plane dislocation density in the epitaxial film, which was measured by using the molten KOH etching and X-ray topograph for the SiC monocrystal substrate with the epitaxial film that was obtained, was 60 cm$^{-2}$ on the average.

[Example 3]

An ingot that was grown by an modified Lely method was sliced at an off-angle of 8° to the off-orientation of the [11-20] direction. The surface of the sliced substrate was smoothed in the specular morphology by mechanically polishing the surface with abrasive grains. The formed n-type 4H-SiC (000-1) substrate was treated by chemical mechanical polishing and hydrogen etching and then an epitaxial film was grown similarly to the Example 2. The surface roughness Rms of the substrate, which was measured based on the method same as that of the embodiment 1 after the treatment, was 0.20 nm (region of 10 $\mu$m × 10 $\mu$m).

The basal plane dislocation density in the epitaxial film, which was measured by using the molten KOH etching and X-ray topograph for the SiC monocrystal substrate with the epitaxial film that was obtained, was 20 cm$^{-2}$ on the average.

[Example 4]

An ingot that was grown by an modified Lely method was sliced at an off-angle of 4° to the off-orientation of the [11-20] direction. The surface of the sliced substrate was smoothed in the specular morphology by mechanically polishing the surface with abrasive grains. The formed n-type 4H-SiC (0001) substrate was treated by chemical mechanical polishing and hydrogen etching and then an epitaxial film was grown similarly to the Example 2. The surface roughness Rms of the substrate, which was measured based on the method same as that of the Example 1 after the treatment, was 0.28 nm (region of 10 $\mu$m × 10 $\mu$m).

The basal plane dislocation density in the epitaxial film, which was measured by using the molten KOH etching and X-ray topograph for the SiC monocrystal substrate with the epitaxial film that was obtained, was 20 cm$^{-2}$ on the average.

[Comparison example 1]

The SiC monocrystal substrate with the epitaxial film was obtained similarly to the Example 1 except that the hydrogen etching treatment was not carried out. The surface roughness Rms of the substrate on which an epitaxial film was grown, which was measured based on the method same as that of the Example 1, was 1.0 nm. The basal plane dislocation density in the epitaxial film, which was measured by using the molten KOH etching and X-ray topograph for the SiC monocrystal substrate with the epitaxial film that was obtained, was 1700 cm$^{-2}$.

In the case in which the epitaxial film was analyzed in detail by X-ray topograph, it was found that a half of the basal plane dislocations of 1700 cm$^{-2}$ was propagated from the substrate to the epitaxial film and another half of the basal plane dislocations was generated during epitaxial growth. That is to say, in the case in which the hydrogen etching treatment was not carried out, it is thought that a lot of basal plane dislocations were propagated from the substrate to the epitaxial film and a lot of the basal plane dislocations were generated during epitaxial growth.

Fig. 4 shows the results of the above described Examples 1 and 2 and Comparison example 1.

[Example 5 and Comparison example 2]

The surface of an n-type 4H-SiC (0001) substrate that was obtained by slicing an SiC ingot was treated by chemical mechanical polishing and hydrogen etching in this order. The epitaxial growth of SiC was then carried out by the CVD method to provide an SiC monocrystal substrate with an epitaxial film. By using the SiC monocrystal substrate, a pn diode as shown in Fig. 3 was fabricated to obtain the pn diode related to the Example 5.

On the other hand, the above treatments were not carried out to the surface of the substrate but the epitaxial growth of SiC was just carried out to provide an SiC monocrystal substrate with an epitaxial film. By using the substrate, a pn diode as shown in Fig. 3 was fabricated to obtain the pn diode related to the Comparison Example 2.

In the case in which the test of a forward voltage degradation was carried out to those pn diodes, an increase in a forward voltage after one-hour current flowing at 100 A/cm$^{-2}$ for the pn diode related to the Example 5 was suppressed to approximately 1/4 as compared with the pn diode related to the Comparison example 2.

**Claims**

1. A bipolar type semiconductor device in which at least a part of a region where an electron and a hole are recombined during current flowing is formed with a silicon carbide epitaxial layer that has been grown from the surface of a silicon carbide substrate, wherein a surface roughness Rms of the surface of the silicon carbide substrate on which an epitaxial growth is carried out is in the range of 0.1 to 0.6 nm.

2. The bipolar type semiconductor device as defined in claim 1, wherein an off-angle of the silicon carbide substrate is in the range of 1 to 4°.

3. The bipolar type semiconductor device as defined in claim 1, wherein a crystal plane of the silicon carbide substrate in which the epitaxial growth is carried out is the (000-1) C plane and an off-angle of the substrate is in the range of 1 to 8°.

4. A process for manufacturing a bipolar type semiconductor device in which at least a part of a region where an electron and a hole are recombined during current flowing is formed with a silicon carbide epitaxial layer that has been grown from the surface of a silicon carbide substrate, wherein the surface of the silicon carbide substrate is treated by hydrogen etching and the epitaxial layer is then formed by the epitaxial growth of silicon carbide from the treated surface.

5. The process for manufacturing a bipolar type semiconductor device as defined in claim 4, wherein the surface of the silicon carbide substrate is treated by chemical mechanical polishing and hydrogen etching in this order, and the epitaxial layer is then formed by the epitaxial growth of silicon carbide from the treated surface.

6. The process for manufacturing a bipolar type semiconductor device as defined in claim 4 or 5, wherein the epitaxial growth is carried out from the surface of the silicon carbide substrate with an off-angle in the range of 1 to 4°.

7. The process for manufacturing a bipolar type semiconductor device as defined in claim 4 or 5, wherein the epitaxial growth is carried out from the (000-1) C plane of the silicon carbide substrate with an off-angle in the range of 1 to 8°.

FIG. 1

$\theta$

3

4

5

4

2

1

FIG. 2

11

15

13

14

12

FIG. 3

FIG. 4

FIG. 5

(a)

Imaging dislocation

Surface

$d$

$d$

Dislocation

$f = - \dfrac{\mu b^2}{4\pi d}$

$d$ : Distance between a dislocation and a surface
$\mu$ : Lame's constant
$b$ : Burgers vector

(b)

Behavior of a dislocation
due to an imaging force

Surface

Threading edge dislocation    Basal plane dislocation

(c)

42

2d

41a

θ

41

(d)

43

41a

2d

41

(e)

2d

41a

θ

41

14

## INTERNATIONAL SEARCH REPORT

| International application No. |
| --- |
| PCT/JP2005/005585 |

A.  CLASSIFICATION OF SUBJECT MATTER
        Int.Cl⁷  H01L21/20, 21/205, 21/302, 21/331, 21/336, 29/73, 29/74,
                29/78, 29/861

According to International Patent Classification (IPC) or to both national classification and IPC

B.  FIELDS SEARCHED

Minimum documentation searched (classification system followed by classification symbols)
        Int.Cl⁷  H01L21/20, 21/205, 21/302, 21/331, 21/336, 29/73, 29/74,
                29/78, 29/861

Documentation searched other than minimum documentation to the extent that such documents are included in the fields searched
        Jitsuyo Shinan Koho          1922-1996    Jitsuyo Shinan Toroku Koho    1996-2005
        Kokai Jitsuyo Shinan Koho    1971-2005    Toroku Jitsuyo Shinan Koho    1994-2005

Electronic data base consulted during the international search (name of data base and, where practicable, search terms used)
        Web of Science

C.  DOCUMENTS CONSIDERED TO BE RELEVANT

| Category* | Citation of document, with indication, where appropriate, of the relevant passages | Relevant to claim No. |
| --- | --- | --- |
| Y | JP 10-261615 A  (Fuji Electric Co., Ltd.),<br>29 September, 1998 (29.09.98),<br>Par. Nos. [0018] to [0024], [0037] to [0038]<br>(Family: none) | 1-7 |
| Y | JP 2002-261041 A  (Sixon Inc.),<br>13 September, 2002 (13.09.02),<br>Par. Nos. [0044] to [0046]; Fig. 12<br>(Family: none) | 1-7 |
| Y | JP 2001-77030 A  (Sanyo Electric Co., Ltd.),<br>23 March, 2001 (23.03.01),<br>Par. Nos. [0005] to [0009]<br>(Family: none) | 4-7 |

[X] Further documents are listed in the continuation of Box C.        [ ] See patent family annex.

| | |
| --- | --- |
| *  Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>    01 June, 2005 (01.06.05) | Date of mailing of the international search report<br>    14 June, 2005 (14.06.05) |
| --- | --- |
| Name and mailing address of the ISA/<br>    Japanese Patent Office | Authorized officer |
| Facsimile No. | Telephone No. |

Form PCT/ISA/210 (second sheet) (January 2004)

## INTERNATIONAL SEARCH REPORT

International application No.

PCT/JP2005/005585

C (Continuation).    DOCUMENTS CONSIDERED TO BE RELEVANT

| Category* | Citation of document, with indication, where appropriate, of the relevant passages | Relevant to claim No. |
|---|---|---|
| Y | Robert T. BONDOKOV et al., "Influence of Structural Defects on the Polishing of Silicon Carbide Single Crystal Wafers", Japanese Journal of Applied Physics, Part 1, Vol.43, No.1, January 2004, pages 43 to 49 | 5-7 |
| O,X | K.S. Lee et al., "Surface Preparation of 6H-Silicon Carbide Substrates for Growth of high-Quality SiC Epilayers", Materials Science Forum, Vols. 457 to 460, 2004, pages 797 to 800 | 1,4,5 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 03038876 A

### Non-patent literature cited in the description

- *Materials Science Forum,* 2002, vol. 389 to 3, 1259-1264